# EUROPEAN PATENT APPLICATION

(11) **EP 1 167 984 A1**
(43) Date of publication of application: **02.01.2002**
(21) Application number: 00113136.6
(22) Date of filing: 29.06.2000
(51) Int. Cl.: G01R 29/08, H01Q 3/38

(54) **Automatic EM field measurement method**

(71) Applicant: Franconi, Cafiero, 00184 Roma (IT)
(72) Inventor: Franconi, Cafiero, 00184 Roma (IT)
(74) Representative: Splanemann Reitzner Baronetzky Westendorp Patentanwälte

(57) **Abstract**

The invention relates to a time-saving method and a system for precise automatic measurements of the spatial distributions of electromagnetic fields with adequate spatial resolution across spatial profiles, surfaces and volumes, including both a narrow-band channel comprising the dipole antenna (21) and the spectrum analyzer (18) and a wide-band channel comprising the isotropic field sensor (43) and the front-end (18'). The system includes both the robot apparatus (101), consisting of arm (3) and antenna configuration mechanism (105), and the system station (102), which includes the system controlling unit (16) exhibiting signal processing and post-processing features. The dipole (21) is configured in space by mechanism (105) to detect three basic projection amplitudes of the local (H)E-field vector which allows to precisely reconstruct the value of the modulus of the field vector.

## Description

### Field of the invention

The invention relates to method and apparatus for precise automatic measurements of the spatial distributions of electromagnetic (EM) fields with adequate spatial resolution across spatial profiles, surfaces and volumes, having uses such as the assessment of the EM pollution level in environmental control of areas and volumes accessible to the population and professional workers by monitoring the maximum field levels. A further use is characterization and testing of the propagation features of EM emitters, hereinafter referred to as emitters, along the manufacturing process.

### Background of the invention

Prior art measurement of EM fields, hereinafter referred to as fields, in the RF, VHF, UHF and microwave frequency bands of radio broadcasting, television, radio links, cellular telephony, satellite communications, etc., is implemented with narrow-band and wide-band detection methods. The narrow-band measurement of either (H)E-field component of a frequency channel of the EM spectrum includes a selection of a frequency channel by either a spectrum analyzer or a selective receiver and is currently performed with multi-band and directive polarized antennae exhibiting a non-isotropic antenna gain and different radiation diagrams for both horizontal and vertical polarization axes, whereby the monitoring precision is scarce on account that currently the direction of each incident beam is not known and that the correction factors for the angular and polarization dependence of the antenna gain with respect to each beam direction and each frequency are also not known and furthermore even for a single originary beam the presence of scattered fields jeopardizes the measurement leading to negative systematic errors. These errors affect also the measurements if employing a polarized multi-band directive antenna with rotating E-field polarization plane layig on two orthogonal planes (Cfr. Raganella *et al*.., *Proc. Nat.I Meeting A.I.R.P*., Brescia, Italy, P. Vecchia ed., 175-178, 1994 ). These intrinsic limitations of directive antennae will suffice to impede the detection of "true" field intensities under the measurement conditions encountered in practice. Moreover, the antennae operating in very wide multi-band frequency ranges, such as the bi-conical, the log-periodic and the YAGI ones, do not exhibit a flat frequency response over their bandwidths adding further precision losses. Moreover, their size is comparable with the largest wavelength to be detected, whereby the detection at smaller wavelengths suffers from poor spatial resolution. It is known to any expert in electromagnetism that E-field dipoles exhibit a quasi perfect spherical radiation diagram, whereby they accurately detect the projection of an E-field vector of a beam incident from any direction along its polarization E-axis, coinciding with the direction of the co-linear dipole active arms. Thus, the modulus of any E-field vector is obtained by detecting the amplitudes of three field projections Eₓ, Ey and E_{z} along the axes of an orthogonal Cartesian {x,y,z} reference frame, from which would be possible to calculate both orientation and modulus of the vector. However, dipoles deliver an output signal of intensity decreasing out of their operating bandwidth.
An isotropic antenna system consists of a mutually orthogonal triad of dipoles assembled with their electric centers as much as possible close to each other. The three detected RF signals from the dipole triad are sequentially processed by an RF front-end including a 3-channel multiplexer, the output of which is sequentially delivering a succession of three RF signals proportional to the projection amplitudes, which are then frequency selected by a spectrum analyzer delivering three DC outputs associated with good approximation to the field vector modulus projection amplitudes of the selected channel, allowing to reconstruct the modulus of the incident E field vector by squaring each projection amplitude, summing them and extracting the square root of this sum. (*see NCRP Report No.19,* "*A practical guide to the determination of human exposure to RF fields*", *page 110-111; Bethesda, Maryland 20814-3095*, *USA);* see *also R. Tell et al., Proc. of* the "*Symposium on Measurements for the Safe Use of Radiation*", *Nat.I Bureau of Standards publ. SP 456*, *1976*). Drawbacks of the latter detection scheme is a loss of accuracy due to: (i) the poor triadic dipole assemblage geometric accuracy with respect to the spatial point to be monitored; (ii) the presence of the local field reflections and scattering of the three dipoles which are crossing each other at very short distances with respect to the radiation wavelength, and: (iii) the difficulty of accurately recovering the three RF signals along the three dipole feeding lines on account of the substantial RF interference due to their very close dipole layout.
In the wide-band method an isotropic sensor is employed, consisting of an orthogonal triadic dipole assembly, each dipole being provided of a square law diode detector so that what is obtained is a DC signal proportional to the sum of the squares of the three field vector Cartesian projection amplitudes of every beam, with the DC full readout corresponding to the local power density of the whole complex isotropic field at all the frequencies within the sensor bandwidth.
Furthermore, the manual point mapping the field over extended spatial profiles, surfaces and/or volumes when searching for high spatial resolution field mapping, requires very long monitoring sessions leading to high survey costs. If an accurate narrow-band survey is sought, under no circumstances it would be practicable to position a single dipole along three orthogonal directions, a protocol which significantly prolongs the time required on any monitoring campaign besides being of very low accuracy.
As well known to people expert in electromagnetism, all above considerations applies also to the measurement of the H-field component of any EM field spectrum using H-field loop type of field sensors and antennae, hereinafter referred to as H-field dipoles, in which the solenoid or the single turn axis is the detection axis of the projection of any vector H-field incident from any direction.

### Summary of the Invention

The present invention provides highly accurate and automatic time-saving method and apparatus for monitoring the representative vector (H)E-field spatial distributions through field measurements on programmable readout positions along pathways within extended areas and volumes and/or including the time profiles of local fields over specific readout positions The fields may have been in many ways generated by emitting stations in all the frequency bands from a fraction of MHz up to 100 GHz either from stations for AM, FM and TV broadcasting, for radio links, for mobile phone or satellite communications, etc., or from antennae undergoing radiation field characterization tests in the manufacturing plant.
- A general object of the invention is an automatic wide-band isotropic (H)E-field intensity monitoring method and related readout protocol by means of a robotic system in combination with an isotropic field sensor to be moved in space along programmed pathways .
- A general object of the invention is an automatic narrow-band vector (H)E-field projection amplitude monitoring method and related readout protocol by means of robotic system provided of an antenna multiple configuration mechanism in combination with antennae of any type moved in space along programmed pathways with their detection axis aiming at any radiation field approaching from any solid angle and with any polarization plane.

- A general object of the invention is an automatic (H)E-field narrow-band field vector modulus monitoring method and related readout protocol by means of a robotic system provided of a mechanism consisting of a rotatable platform and a tilting joint and a control station in combination with an antenna moved in space along programmed circular trajectories with the detection axis rotating about two orthogonal configurations of its polarization plane.
- Another general object of the invention is an automatic narrow-band vector (H)E-field modulus monitoring methods and related readout protocol by means of a robotic system provided of a rotatable platform mechanism and in combination with either an external p-dipole or a directive p-antenna.
- Another general object of the invention is an automatic narrow-band vector (H)E-field modulus monitoring method and related readout protocol by means of a robotic system provided of a rotatable platform mechanism and in combination with either an external b-dipole or a directive b-antenna.
- Another general object of the invention is an automatic narrow-band vector (H)E-field modulus monitoring method through its Cartesian projections by means of a robotic system provided of a mechanism with two linear and one rotational degrees of freedom in combination with either an external p-dipole or a directive p-antenna.
- Another general object of the invention is an automatic narrow-band vector (H)E-field modulus monitoring method through its Cartesian projections by means of a robotic system provided of a mechanism with two rotational degrees of freedom and in combination with either an external p-dipole or a directive p-antenna.
- Another general object of the invention is an automatic (H)E-field monitoring method and related readout protocol by means of a robotic system for the simultaneous readout of both wide-band field intensities and narrow-band field vector modulus in combination with an isotropic wide-band sensor and a p-dipole, respectively.
- Another general object of the invention is an automatic (H)E-field monitoring method and related readout protocol by means of a robotic system for the simultaneous readout of both wide-band field intensities and narrow-band field vector modulus in combination with an isotropic wide-band sensor and a b-dipole, respectively.

- Another general object of the invention is an automatic (H)E-field monitoring method and related readout protocol by means of a robotic system for the simultaneous readout of both wide-band field intensities and narrow-band field amplitudes in combination with an isotropic wide-band sensor and a directive antenna , respectively.
- According to the present invention the robot apparatus includes a track-guided robot with a structured arm featuring a main base guided along a main track and connected to a vertically guided hoist.
- According to the present invention the robot apparatus includes a structured arm featuring a main base jointed to a vertically guided hoist connecting a second base guiding the radial movement of a substantially horizontal track.
- According to the present invention the robot apparatus includes a structured arm featuring a main base jointed to a vertically guided hoist connecting a substantially horizontal track guiding the radial movement of a second base.
- According to the present invention the robot apparatus includes structured arms embodied with vertically guided hoists actuated by cylinder, or belt-pulley or else geared devices or a combination of them.
- According to the present invention the robot apparatus includes a structured arm featuring a main base provided of a main platform connected to said main base through a preferably vertical rotatable joint, with said platform jointed to a vertically guided hoist for monitoring extended volumes.
- According to the present invention the robot apparatus includes a structured arm featuring a vertically guided hoist actuated by either a cylinder or by a belt-pulley or geared lift mechanism.
- According to the present invention the robot apparatus includes a structured arm with movements according to a cylindrical symmetry.
- According to the present invention the robot apparatus includes a structured arm with movements according to a spherical symmetry.
- According to the present invention the robot apparatus includes a structured arm with movements according to a Cartesian symmetry.
- According to the present invention all the robot apparati are manufactured with non-metallic and non-conductive materials and/or are covered by field absorbing materials.
- According to the present invention all the robot apparati are manufactured keeping sensors, dipoles and directive antennae at a distance from each other and from robot parts.
- According to the present invention the robot apparati may be provided of a multi-element track embodied by interconnected track elements.
- According to the present invention the control stations of all the robot apparati include a programmable hierarchical process controller system and system software modules for generating the pathways, for the robot running mechanism control and for narrow-band and wide-band signal processing and post processing.

### Detailed description of the drawings

FIGURE 1 is a block diagram of the basic narrow-band (H)E-field monitoring system for EM fields readout according to the invention.

FIGURE 2 is a view with parts cut away of an embodiment according to the invention of the (H)E-field detection scheme employing the p-dipole for monitoring the modulus of the field vector.

FIGURE 3 is a view with parts cut away of a dipole detection scheme according to the invention for recovering three basic projections of the field vector.

FIGURE 4 is a view with parts cut away of an embodiment of the (H)E-field detection scheme according to the invention employing the b-dipole for monitoring the modulus of the field vector.

FIGURE 5 is a view with parts cut away of a Cartesian multiple p-dipole configuration mechanism embodiment according to the invention with two linear and one rotational degrees of freedom.

FIGURE 6 is a view with parts cut away of a further Cartesian multiple p-dipole configuration mechanism embodiment according to the invention with two rotational degrees of freedom.

FIGURE 7 is a view with parts cut away of the block diagram of a narrow-band monitoring system provided of a multiple antenna configuration mechanism embodiment according to the invention for monitoring intensities of (H)E-fields from any direction with multi-band directive antennae and dipoles.

FIGURE 8 is a view with parts cut away of the block diagram of a narrow-band monitoring system provided of a multiple antenna configuration mechanism embodiment according to the invention for monitoring averaged (H)E-fields vector modulus with a rotating multi-band directive antenna through both orthogonal polarization planes.

FIGURE 9 is a view with parts cut away of the block diagram of the basic wide-band isotropic (H)E-field monitoring system according to the invention.

FIGURE 10 is a view with parts cut away of the block diagram of the dual channel wide -band and narrow-band (H)E-field basic monitoring system according to the invention.

FIGURE 11 is a view with parts cut away of the block diagram of a track based robot embodiment according to the invention for (H)E-field automatic monitoring across extended surfaces.

FIGURE 12 is a view with parts cut away of the block diagram of the floor standing base robot embodiment according to the invention for (H)E-field automatic monitoring across extended surfaces.

FIGURE 13 is a view with parts cut away of the block diagram of the floor standing base robot embodiment according to the invention for (H)E-field automatic monitoring across extended surfaces.

### Embodiments

To achieve the foregoing and other objects according to the present invention as embodied and described therein, preferred embodiments are disclosed each of them falling under the scope of the present invention, which is to provide automatic methods and apparatus for monitoring the spatial distributions across extended areas and volumes of the (H)E-field component of the EM spectrum with antennae and sensors in narrow-band and wide-band modalities, respectively.

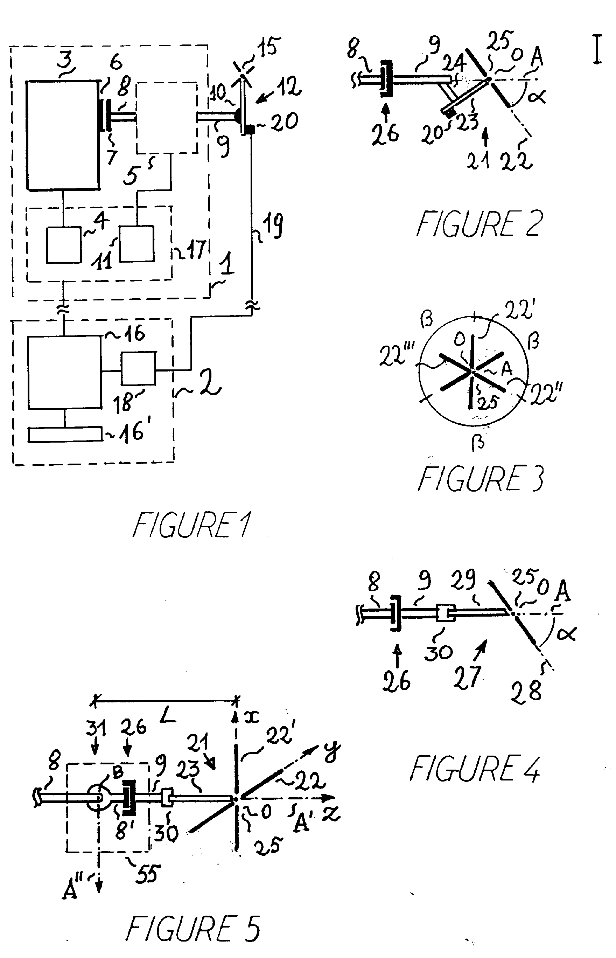

**FIGURE 1** shows the block diagram of a preferred embodiment of a system for automatic narrow-band (H)E-field monitoring which includes robot (1) and control station (2) interconnected by electric cabling of adequate lengths to avoid the scattered fields from the station cabinet perturbing the field in the vicinity of the detectors. The robot apparatus (1) comprises structured arm (3) the movement of which is driven by the arm drive (4) controlled by station (2). Arm (3) is the elongated appendage which is running the antenna multiple configuration mechanism (5) which is the changeable element carrying out the intended function of moving an external antenna. Arm (3) terminates with the load supporting flange (6) which detachably connects to the counter-flange (7) to which mechanism (5) is attached by the input shaft (8). The mechanism output arm (9) terminates with antenna holder (10). The drive (11) actuates the movements of mechanism (5). The system according to the invention operates in combination with the field monitoring antenna (12) detachably mounted on holder (10), whereby the antenna detection axis is configured in space by the related configurations of holder (10) and of arm (9). In **FIGURE 1,** antenna (12) is embodied by an E-field half-wavelenght dipole for purposes of illustration; however it can be replaced by H-field magnetic monopoles or by any other type of (H)E-field antennae without departing from the scope of the invention. In order to have the electric symmetry center (15) of the detection axis passing through the readout positions along the programmed time-dependent interpolating pathways, the control station (2) includes the system process controller (16) which is conditioning the robot motion drives (4) and (11) of the robot actuating unit (17). Controller (16) is also controlling the spectrum analyzer (18), which performs the amplitude readout of selected frequency channels out of the RF signals from antenna (12) via antenna connector (20) and RF cable (19). Controller (16) includes hardware and software for further processing the spectrum analyzer (18) output signals and for post-processing and correlating antenna readouts with the related antenna positions, establishing also links to a local and/or remote terminal and power links to a local or remote power source. The preferred embodiment of **FIGURE 1** carries the following advantages: (i) much higher precision and accuracy in monitoring specific points of given spatial coordinates, ii) detecting local fields with any specific polarization, on account of the possibility of configuring in space the detection axis of antenna (12) through configuration mechanism (5) and antenna holder (10), and (iii) drastically reducing monitoring time and associated costs .

**FIGURES 2, 3** and **4** illustrate preferred embodiments of the narrow-band monitoring protocol carried out with the basic system of **FIGURE 1** equipped with E-field dipoles for accurately monitoring the modulus of the E-field vector, which is accurately reconstructed through the measurements of three basic projection amplitudes of the vector with the dipole detection axis assuming a set of basic configurations along the axis of a basic reference frames while keeping the electric symmetry center superposed to the point to be monitored.
In the preferred embodiment of **FIGURE 2,** the detection axis (22) of the p-dipole (21) is internally configured to coincide with the dipole detection arm and is perpendicular to the feeding conductor (23). Holder (24) is shaped to hold (23) angled of 35.26° to the rotation A-axis, while conductor (23) length is adjusted whereby the electric center (25) lies along the A-axis. During arm (9) rotations the detection axis (22) describes a conical surface angled of 54.74° with respect to the A-axis with the p-dipole center (25) always superposed to the point (O). A preferred embodiment of the configuration mechanism includes the turntable (26), supported by the shaft (8), transmitting the rotatory motion to the holder (24) through the output arm (9). The protocol includes having output arm (9) performing three (β) angular rotations of 120° to position the detection axis (22) on the three symmetric angular readout configurations (22'), (22") and (22"') of FIGURE 3 in coincidence with analyzer (18) carrying out the readout of the related three projection amplitudes of the E-field vector modulus to be associated to the point (O) and delivering the three related dc output signals which are further processed by system controller (16) to reconstruct the modulus of the E field vector by squaring each signal amplitude, summing them and extracting the square root of this sum. (see *H. I. Bassen and G. S. Smith,* "*Electric Field Probes. A Review"*, *IEEE Trans. on Antennas and Propagation, Vol. AP-31*, *pp. 710-718, 1983).* People expert of EM measurements know that the same protocol may be employed for monitoring the (H)E-field vector modulus with smaller spatial resolution and accuracy employing a single-band or multi-band and or directive p-antenna including the single-band or multi-band YAGI or biconical or log-periodic types of directive p-antennae, with these p-antennae having their feeding conductors integrated into the RF connector at right angle with the p-antenna detection axis, with the RF connector preferably positioned at the electric symmetry center of the p-antenna.

With reference also to the FIGURES 2 and 3, in the preferred equivalent embodiment of **FIGURE 4,** the output arm (9) of turntable (26) is instead terminated with the coaxial dipole holder (30). The bent b-dipole (27) is internally configured with the detection axis (28) angled of 54.74° to the RF feeding conductor (29) (see: *H. I. Bassen and G. S. Smith, loc. cit.).* Conductor (29) is detachably mounted on the coaxial holder (30) whereby rotations of arm (9) about the A-axis keeps the b-dipole detection axis (28) always angled of 54.74° to the A-axis and the same readout protocol of the p-dipole applies as well. People expert of EM measurements know that the same protocol may be employed for monitoring the (H)E-field vector modulus with smaller spatial resolution and accuracy employing a single- or multi-band and or directive b-antenna, including the single-band or multi-band YAGI or biconical or log-periodic types of directive b-antennae, with these p-antennae having its feeding conductors ,integrated into the RF connector, at the angle of 54.74° to the RF b-antenna detection axis, with the RF connector preferably positioned at the electric symmetry center of the b-antenna.

Field vector modulus determinations by Cartesian sets of field projections are embodied in many ways with two or more degrees of freedom robotic arm without departing from the scope of the invention. With reference to FIGURE 1, in the preferred Cartesian scheme embodied in **FIGURE 5,** the detection arm (22) of p-dipole (21) assumes three orthogonal readout configurations along the x, y and z axes of the Cartesian frame whose origin (O) is the position to be monitored. The embodiment comprises one rotational and two linear movements. Mechanism (5) comprises the 90° tilting joint (31) which is tilting its output tilt housing and shaft (8') of 90° about the B-axis. Shaft (8') is supporting turntable (26) rotating about the A'-axis. The rotatable output arm (9) from turntable (26) terminates with coaxial holder (30) holding dipole conductor (23) along the A'-axis with the detection arm (22) along the y-axis for the first field vector projection readout. The second readout is made after a 90° rotation of turntable (26) driven by mechanism actuator (11) to align detection arm (22') with the x-axis. A 90° tilting of shaft (8') by joint (31) actuated by drive (11) rotates the p-dipole so that the A'-axis assumes the A"-axis configuration, with the detection arm (22) aligned with the z-axis for the third projection readout. The latter rotation displaces p-dipole center (25) from (O) of length L along both the y- and the z-axes, L being the distance between (25) and the B-axis, which is to be compensated with two equal back translations of the load supporting flange (6) of arm (3).

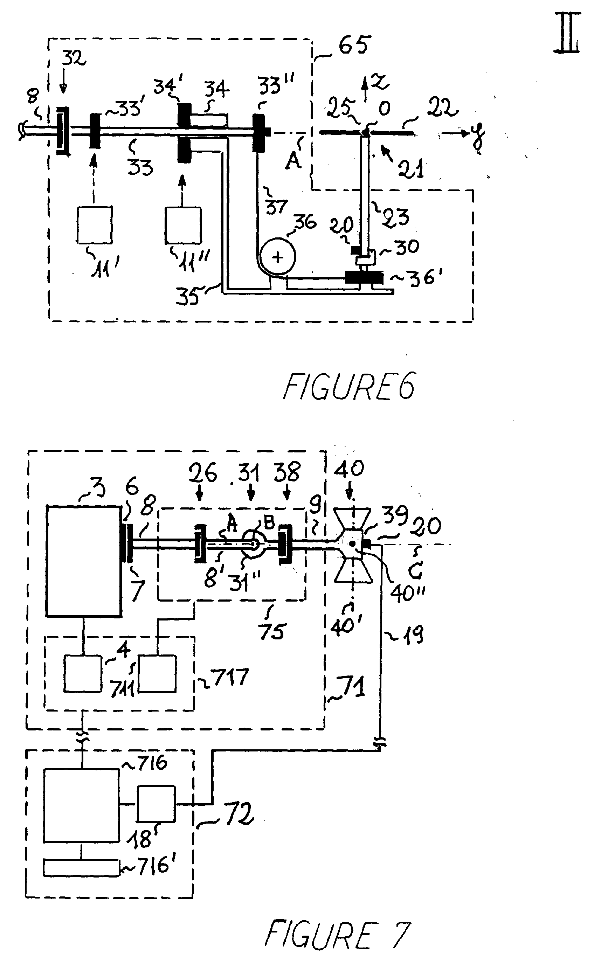

With reference to FIGURE 1, in **FIGURE 6** the further preferred Cartesian scheme is shown, in which the preferred embodiment of configuration mechanism (65) supported by shaft (8) includes the roll joint (32) allowing free rotations to the coaxially rotatable inner arm (33) provided of pulley (33') and driven to rotate about the A-axis by the rotatory belt actuator (11'). The outer platform (34) and attached pulley (34') freely rotates about inner arm (33) and is independently driven at the pulley (34') by belt actuator (11") which is controlled to perform alternate 90° rotations about the A-axis. Platform (34) is provided of the L-shaped two-member appendage (35) supporting the power drive transmission to the p-dipole (21) from inner arm (33) through pulleys (33"), (36) and (36') and belt (37). Pulley (36') is equipped with the coaxial p-dipole holder (30) holding conductor (23) with the detection arm (22) lying along the y-axis for the first projection readout. Successively, the inner arm (33) is independently driven to rotate of 90° the dipole detection axis (22) about the z-axis to assume the x-axis second readout configuration. The third readout configuration is obtained with a 90° rotation of platform (34) and of a compensated 90° inner arm (33) rotation adjusted to lie the dipole detection arm (22) along the z-axis.

People skilled in the art of EM measurements know that the dipole-holder configurations of **FIGURES 2, 4, 5, 6** and **10** are intended to keep holders far away from the dipoles detection arms and electric symmetry centers to minimize EM interference; however, any dipole, as well as any antenna employed in narrow-band monitoring, may be either held or else rotated right at the electric center and basic Cartesian frame projection amplitudes may be obtained with a two rotational degrees of freedom mechanism. It is further evident to people skilled in the art that any complex rotary motions such as those of **FIGURES 5** and **6** and equivalent ones, may be embodied with many different kinematics mechanisms including gear boxes and/or flexible arms for any composite rotary/linear movements for obtaining the three orthogonal field projections compatible with the symmetry restrictions imposed by type and number of degrees of freedom of the structured arm and configuration mechanism and by their driving actuators and control software, and that all of them are not departing from the scope of the invention. People expert in electromagnetism further know that the methods and apparati for narrow-band detection disclosed in the **FIGURES 1-6** fall within the scope of the invention also if the embodiments relate to : i) a variety of alternative readout reference frames such as polar or cylindrical ones, for field vector decomposition into univocal basic sets of field components with the implementation of related protocols for modulus amplitude reconstruction, ii) readout reference frames randomly oriented in space about the position (O) to be monitored, and iii) a variety of dipoles including quarter- and half-wavelength ones exhibiting any detection arm-conductor configuration together with compatible readout reference frames.

The preferred embodiments illustrated in the **FIGURES 2-6** are innovative and useful in the method of detecting the field vector modulus in space with respect to any dipole 120° triad fixed assembly (see: *H. I. Bassen and G. S. Smith, loc. cit.*) and in the orthogonal triad assembly of the prior art (see: *R. Tell et al.*, *loc. cit*.) in that the electromagnetic detecting head, consisting of a single dipole. Moreover, these embodiments are innovative in employing a mono-channel signal processing method, which carry practical and useful advantages with respect to the multichannel prior art ones, leading to much higher precision, accuracy and stability. In fact, the use of a single dipoles and a mono-channel front-end avoids all problems connected with: (i) the implementation of high sensitivity RF multiplexed receivers, (ii) the inter-dipole electromagnetic disturbances occurring when employing RF dipole triads, (iii) the low spatial resolution due to the relative dislocation of the three dipole electric centers as present in the triads, and (iv) the higher manufacturing and optimization costs of any triad assembly.

People skilled in the art will recognize that without departing from the scope of the invention the automatic method for narrow-band monitoring of spatial distributions of (H)E-field may be embodied with any type of alternative (H)E-field antennae including any type of single-band dipole and any single-band or multi-band YAGI or biconical or log-periodic types of directive antennae. Thus, the basic automatic method shown in the FIGURE 1 may preferentially be embodied with a configuration mechanism capable of aiming all said antennae along any direction in space to detect (H)E-field vector projection intensities with any orientation of their polarization plane. Employing the multi-band and directive biconical antenna (40) for illustrating the measurement protocol according to the invention extensible to all the other antennae and dipoles of analogous internal configuration, in **FIGURE 7,** a preferred mechanism embodiment (75) of robot (71) is shown in which shaft (8) supports the rotatable platform (26) which rotates its output arm (8') about the A-axis and the connected fork arm of tilting joint (31), the tilt housing (31") of which is swinging about the orthogonal B-axis and terminates with the rotatable platform (38) the output arm (9) of which rotates about the further orthogonal C-axis and terminates with holder (39) of the bi-conical antenna (40). Turntables (26), (31) and (38) are actuated by the programmable system control unit (16) through the mechanism actuating unit (17) to aim the polarized detection axis of antennae at any direction in space with any orientation of the antenna polarization plane in order to monitor specific projections features of selected frequency channels of the (H)E-field vector.

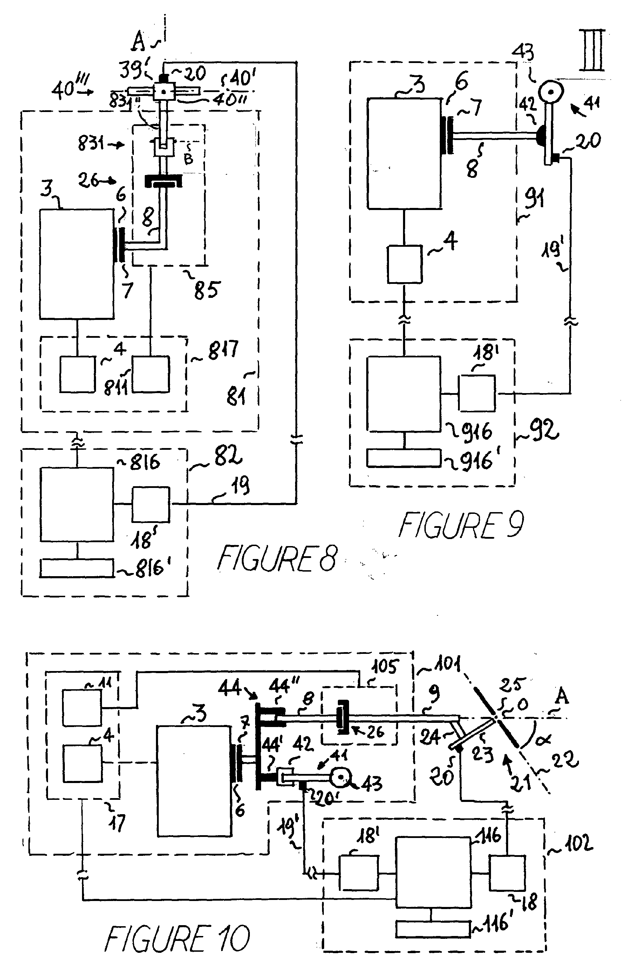

For the automatic determination of the modulus of the (H)E-field vector, a preferred dynamic protocol (see: *L. Raganella*, *S*. *Mancini and M. Di Costanzo, loc*. *cit.* ) is embodied according to the invention as in **FIGURE 8,** in which mechanism (85) includes the preferentially vertical input shaft (8) joined to the input flange of platform (26) rotatable about the A-axis the output of which is joint to the 90° tilting joint (831). The tilt housing (831") directly connects to holder (39) of the bi-conical p-antenna (40) at the electric symmetry center (40") of its detection axis (40').
The signal processing unit (816) is programmed whereby actuator (811) drives the turntable (26) to have joint (831) and holder (39) executing a first set of forward and reverse alternate rotations of about 360° about the preferably vertical A-axis, whereby the antenna detection axis (40') is swept horizontally back and forth along an horizontal circular trajectory as in FIGURE 8.
The 90° tilting of housing (831") switches of 90° the detection axis (40') and a second set of alternate horizontal rotations of about 360° of the antenna axis (40') are made by (26) about the A-axis. The signal processing unit (816) calculates the peak and/or average field amplitudes detected during each set of rotations and their RMS value, which is assumed representative of the peak and/or the average modulus of the field vector referred to the position of the center of antenna (40). If the housing (831") is short with respect to the wavelength, the ambiguity in the position of (39) on account of the 90° tilting is not significant. People skilled in the art will recognize that without departing from the scope of the invention, both mechanisms (75) and (85) may be embodied with any type of joints to perform the same task in combination with any alternative p-antennae and p-dipoles.

Expert people further recognize that the preferred embodiments of **FIGURES 1-8** and those derived from them are employed without departing from the scope of the invention also for other purposes different from (H)E-field projection or modulus recovery, including: (a) the detection and analysis of any type of electromagnetic structure of any frequency channels in the presence of complex analog and/or digital modulation schemes of the fields utilized in telecommunications; (b) pointing the dipoles or other antennae detection axes towards any direction in space in order to monitor specific field polarization parameters; (c) processing the signals with proper readout schemes for recovering further information out of the EM field, and employing detection axis configurations either static or dynamic, either single or multiple, etc.; (d) using different signal processing protocols for obtaining quantitative as well as qualitative information about the weighting functions of any plurality of frequency channels, and (e) for measuring the radiation ((H)E-field spectrum emitted by radiating sources for the purposes of either certifying the harmonics and spurious content or for emitters optimization.

With reference to the basic system of FIGURE 1, a preferred embodiment of the system including robot (91) is shown in **FIGURE 9** for automatic monitoring the spatial distributions of the (H)E-field isotropic field intensity in combination with the external (H)E-field wide-band sensor (41) and the associated dc front-end device (18') connected via connector (20') and cable (19'). Sensor (41) is held by holder (42) which is attached to the distal end of shaft (8). At the proximal end, shaft (8) is attached to the counter-flange (7) connected to the load supporting flange (6) of robot structured arm (3). The programmable system controller (16) is processing the dc signals detected by the isotropic head (43) of the sensor to be superposed to the point (O) to be monitored by the movements of arm (3) driven by (4) under control of station (92).

A further preferred embodiment of an automatic method for simultaneously monitoring the spatial distributions of both the wide-band (H)E-field isotropic intensities and the narrow-band (H)E-field projection amplitudes or field vector modulus values is illustrated with the block diagram of **FIGURE 10.** This dual-channel embodiment is referred to the single-channel embodiments of **FIGURES 2, 3, 6, 7** and **9.** The counter-flange (44) to flange (6) includes attachment members (44') and (44"). The member (44') terminates with sensor holder (42). The shaft (8) attached to (44") is the input shaft of the mechanism (105) driven by actuating unit (11). The output arm (9) of (105) terminates with the angled holder (24) holding the p-dipole (21) as in the **FIGURE 2,** whilst sensor (41) is mounted on holder (42) . Shaft (8), arm (9) and sensor holder (42) are configured at optimized angles, lengths and inter-distance minimizing EM interference between antenna (21) and sensor (41) readouts. Expert people know that in the embodiment of **FIGURE 10,** for narrow-band (H)E-field monitoring, the p-dipole (21) may be replaced for narrow-band (H)E-field detection by any other types of p-antennae, including b-dipoles and single-band, multi-band and/or directive b-antennae, by utilizing both the disclosed proper mechanisms and antenna holder configurations for carrying out the disclosed narrow-band detection protocols without departing from the scope of the invention.

Specific embodiments of the control station (2) with the programmable system processing unit (16) which is hierarchically controlling the systems operations with the help of the system software (16'), allow the control of each specific embodiment of the present invention illustrated in the **FIGURES 1-13** and/or derived from them without departing from the scope of the invention. The system software (16') includes the following related software modules that are developed with algorithms well known to any expert programmer and implemented in number and specifications as required by the selected embodiment illustrated in the **FIGURES 1-13** and/or derived from them without departing from the scope of the invention.
- Narrow-band processing software module for a specific control of the settings of the analyzer (18) and for the specific processing of the readout signals out of (18) for all the narrow-band embodiments according to this invention ;
- Wide-band processing software modules for specific control of the settings of the front-end (18') and for the specific processing of the readout signals out of (18') for all the wide-band embodiments according to the invention;
- Software modules for generating specific 1D, 2D, and 3D spatial and time-controlled pathways;
- Robot controlling software modules for specific control of the arm drive (4) and the mechanism drive (11) of the motion actuating unit (17) according to each specific detection protocol and to each related specific spatial pathway embodied;
- Post-processing software modules for correlating the processed signal values detected with all the embodied protocols for each readout position with the related coordinates of said positions along said pathways to produce and display the spatial distributions of the (H)E-field.

The control of the robot apparatus is related to the programmed readout positions and related interpolating 1D, 2D or 3D pathways or any combination of them that are to be monitored by the antennae and sensors at their symmetry centers include a complex programming of the composite rotary/linear movements of compatible symmetry of the robot apparatus which are conditioned by type and number of degrees of freedom of structured arm and of the configuration mechanism embodiments and by the size and conformation of sensors and antennae. The robot running mechanisms includes a motion actuating unit (17) comprising arm drive (4) and mechanism drive (11), each embodied with specific actuation modules , which are selected in number and type according to the current automation technology well known to the experts in this field in relation to the different functions requested to the structured arm (3) and mechanism (5) within the system configurations embodied as described in the present invention and/or derived from them without departing from the scope of the invention.

As regards the movements of structured arm (3) of the embodiments of **FIGURES 1-10,** these include a relative number of linear vs. rotary joints characterizing the degrees of freedom of arm (3), which may preferably be alternatively embodied as: (i) a Cartesian arm , which has 3 degrees of freedom constituted by orthogonally related linear movements; (ii) a cylindrical arm, which has at least 3 degrees of freedom constituted by one rotary, the other two being orthogonally related linear movements; (iii) a spherical arm, which has at least 3 degrees of freedom constituted by two orthogonal rotary joints and one linear movement, and: (iv) combinations of either more or less than 3 degrees of freedom arm (3) comprising any number of arm rotary joints about axes of any orientation and any number of linear related movements along any direction for determining any type of flange (6) orientation and movement in space.

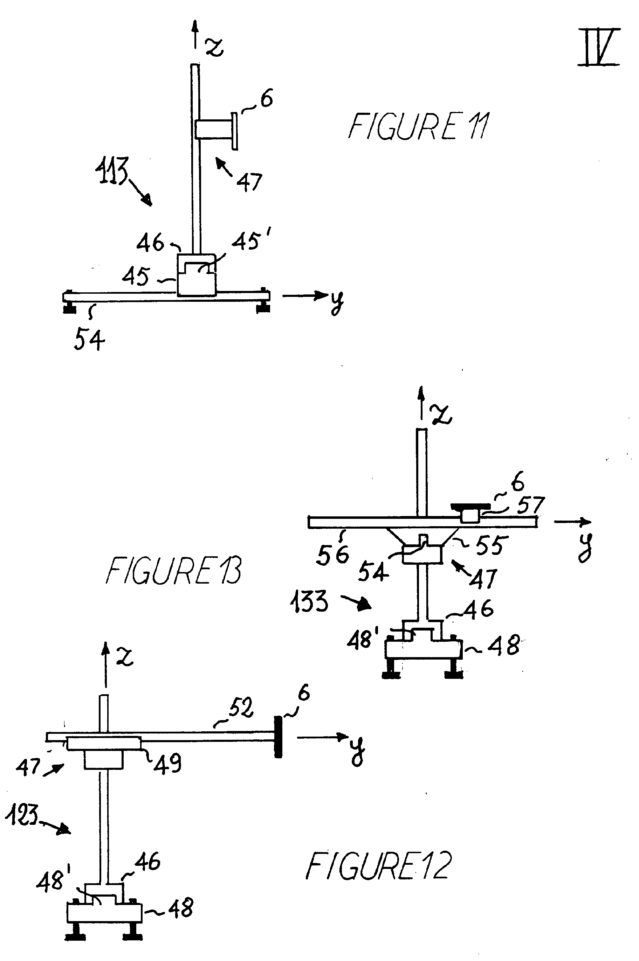

In **FIGURE 11,** a preferred embodiment of a 2D structured arm (3) for moving flange (6) on the {y,z} plane is shown. The track-guided Cartesian arm (113) includes the floor standing main track (54) guiding the movable main base (45) with the attachment member (45') on which the main stand (46) of the vertically guided hoist (47) carrying the flange (6) is detachably connected. The running mechanism controlled by the programmable control unit (16), is positioning main base (45) and hoist (47) at specific and related coordinates along the y-axis and z-axis tracks, respectively.

**FIGURE 12** shows another preferred embodiment of a 2D structured arm (3) for moving flange (6) on the {y,z} plane. The Cartesian arm (123) includes the floor standing main base (48) with the attachment member (48') detachably connecting to the stand (46) of the vertically guided hoist (47) supporting the fixed second base (49) guiding the radial movement along the y-axis of a mobile light arm provided of track (52) which is terminating with flange (6). The programmable control unit of the arm running mechanism is positioning track (52) and hoist (47) at specific and related coordinates along the y-axis and z-axis tracks, respectively.

In **FIGURE 13** a preferred embodiment of a 2D structured arm (3) for moving flange (6) on the {y,z} plane is shown. The Cartesian arm (133) includes the floor standing main base (48) and attachment member (48') detachably connecting to the hoist stand (46) of the vertically guided hoist (47), said hoist being provided of the second attachment member (54) supporting the platform (55) which in turn supports a fixed and preferably horizontal light arm provided of track (56) guiding the radial movement along the y-axis of a movable second base (57) carrying the flange (6). Controlled by the programmable control unit (16), the arm actuating unit is positioning base (57) with the flange (6) and hoist (47) at specific and related coordinates along the y-axis and z-axis tracks, respectively.

For 3D monitoring, the main platform (46) mounted on the main stand (46) of arm (123) is embodied to be rotatable about a vertical axis with respect to the floor standing base (48) with the insertion of an additional rotatable joint in between main stand (46) and main base (48), whereby hoist (47) and track (52) are horizontally swingable of about 360° about the z-axis, actuated by a further drive within the arm actuating unit (17), with the flange (6) positioned over the points within a cylindrical volume characterized by the track diameter and the hoist track height. Analogous result is obtained if a rotatable joint is inserted in between the main stand (46) and the main base (48) of arm (133). Alternatively, if a spherical joint is instead inserted between the main base (48) and main stand (46) of arms (123) and (133), the hoist (47) is made swingable towards any useful angle characterizing tilted cylindrical volumes to be monitored.

According to the invention, all the mechanical parts embodiments of the robot are manufactured with non-metallic and/or non-conductive materials and /or covered with radio waves absorbers to avoid spurious secondary beams arising from scattering. In order to minimizing still further secondary beam scattering effects, the parts of robot (1) adjacent to the holders are embodied with configurations and sizes that offer a minimal cross-section, compatibly with their intended functions, with respect to the sensors, antennae or dipoles monitoring heads.

According to the invention, when field monitoring is to be carried out along pathways of length longer than that of the robot tracks, multiple tracks out of mechanical couplings inter-between detachable track elements of any shape and length are employed. Moreover, when monitoring is due to be carried out at the intersections of an extended multi-point grid, multi-track grids are employed out of mechanical couplings interbetween detachable track elements of any shape and length along which robot (1) is guided to move.

According to the state of the automation art, the floor standing main bases (48) and the tracks (54) may have peripheral threaded holes in which threaded leveler bolts (58) are wound for supporting them at any preferred angle with respect to the floor. Bolts or detachable weights may also be employed to keep the base or track anchored to the floor.

According to the invention, the sources of the force displacing bases along the tracks and of torque for rotating platforms, turntables, pulleys and tilt housings of robot apparatus according to the invention may alternatively include either manual actuation or else fluidic, electric or stepper motors and related actuating kinematics mechanisms, and the hoist (47) of the **FIGURES 11-13** may be a cylinder actuator or a belt-pulley or else a geared lift device or a combination of all these actuating means. Moreover, joints, attachments and coupling means in all the mechanical embodiments of robot apparatus according to the invention may be detachable according to automation practice. Servo-actuators and/or position sensors may be included if a closed loop controlling embodiment is selected to return positions information to the control units allowing accurate positioning with driving means embodiments.

It is apparent to any electromagnetic field expert, that the monitoring method embodiments illustrated in **FIGURES 1-13,** and those derived from them by extensions, modifications and combinations, fall within the scope of the invention and are suited to monitor spatial distributions of (H)E-field amplitudes or field vector modulus within extended surfaces and volumes with either wide-band and/or narrow-band modalities.

## Claims

1. A wide-band method for automatic monitoring the spatial distributions of the intensity of the isotropic (H)E-field over readout positions along programmable pathways within extended areas and volumes in combination with the isotropic field sensor (41) and associated front-end device (18') delivering readout isotropic field intensities, said method comprising:
providing a robot apparatus (91) including a structured arm (3) terminating with the load supporting flange (6), said flange being detachably joined to the counter-flange (7), said counter-flange being provided of output shaft (8), said shaft being terminated by sensor holder (42), said holder detachably mounting said sensor (41), said apparatus including the robot arm drive (4);
providing a system control station (92) comprising:
- said front-end device (18'), said device being connected to said sensor through connector (20') and cable (19');
- a programmable system processing unit (916), said processing unit controlling said arm drivr (4) and said front-end (18') and exhibiting signal processing and post-processing features;
- a system software (916') comprising:
an arm drive (4) controlling module to have the electric center (43) of said sensor positioned over said readout positions along said programmable pathways,
a wide-band signal processing module controlling said front-end (18') and performing a pre-processing of said readout field intensities,
a module for generating said readout positions and said pathways,
a related post-processing module for correlating said processed readout field intensities to said readout positions along said pathways to produce and display said isotropic field intensity spatial distributions.

2. A narrow-band method for automatic monitoring the spatial distributions of the amplitudes of (H )E-fields over readout positions along programmable pathways within extended areas and volumes, in combination with an external antenna and associated spectrum analyzer (18), said antenna being a directive antenna (40), said method comprising:
- providing a robot apparatus (71) including a structured arm (3) terminating with the load supporting flange (6), said flange being detachably joined to the counter-flange (7), said counter-flange being provided of shaft (8), said robot apparatus being provided of the antenna multiple configuration mechanism (75), the input of said mechanism being connected to said shaft (8), the output arm (9) of said mechanism terminating with antenna holder (39), said holder detachably mounting said antenna (40) whereby the detection axis (40') of said antenna is configured in space by said configuration mechanism, said mechanism comprising a first platform rotatable about the A-axis and connected to the input fork arm of tilting joint (31), the tilt housing (31") of which is swinging about the orthogonal B-axis and connects to the rotatable platform (38) terminating with the arm (9) rotated about the further orthogonal C-axis, said robot apparatus including the robot motion actuating unit (717) consisting of arm drive (4) and mechanism drive (711);
- providing a system control station (72) comprising:
- said spectrum analyzer (18), said analyzer being connected to said antenna through connector (20) and cable (19);
- a programmable system processing unit (716), said processing unit controlling said robot actuating unit (717) and said analyzer (18) and exhibits signal processing and post-processing features;
- a system software (716') comprising:
a robot motion module comprising software for controlling said mechanism drive (711) to have the detection axis of said antenna assuming programmed readout configurations and related software for controlling said arm drive (4) to have the electric center (40") of said antenna detection axis positioned over said readout positions along said programmable pathways,
a narrow-band signal processing module controlling said analyzer (18) and performing a pre-processing of said readout field amplitudes,
a module for generating said readout positions and said pathways,
a related post-processing module for correlating said processed readout field amplitudes to said readout positions along said pathways to produce and display said field amplitude spatial distributions.

3. A method according to Claim **2** in which said antenna is any type of (H)E-field dipole.

4. A narrow-band method for automatic monitoring the spatial distribution of the modulus of the (H)E-field vector through the detection of either peak and/or averaged orthogonal projection amplitudes of said vector over spatial readout positions along programmable pathways within extended areas and volumes, in combination with an external antenna and associated spectrum analyzer (18), said antenna being a directive p-antenna (40) presenting the detection axis (40') perpendicular to the p-antenna holder (39'), said holder (39') being inclusive of the feeding conductors of said antenna (40), said method comprising:
- providing a robot apparatus (81) including a structured arm (3) terminating with the load supporting flange (6), said flange being detachably joined to the counter-flange (7), said counter-flange being provided of shaft (8), said robot apparatus being provided of the antenna multiple configuration mechanism (85) the input of which is connected to said shaft (8), said mechanism comprising platform (26) rotatable about the preferentially vertical A-axis and connected to the input fork arm of the 90° tilting joint (831), the tilt housing (831") of which is driven to swing from a preferentially vertical direction to the horizontal direction about the B-axis, said housing directly connects to the antenna holder (39'), said holder holding said antenna (40"') preferentially at the position of the center (40") of its detection axis (40') whereby said detection axis (40') of said antenna is laying in a preferentially horizontal configuration, said robot apparatus including the robot motion actuating unit (817) consisting of arm drive (4) and mechanism drive (811), said drive (811) comprising a drive for said tilting joint (831) and also a drive for said rotatable joint (26);
- providing a system control station (82) comprising:
- said spectrum analyzer (18), said analyzer being connected to said antenna (40) through connector (20) and cable (19);
- a programmable system processing unit (816), said processing unit controlling said robot actuating unit (817) and said analyzer (18) and further exhibits signal processing and post-processing features,
- a system software (816') comprising:
a robot motion module comprising software for controlling said arm drive (4) to have said electric center (40") of said detection axis (40') positioned over said readout positions along said programmable pathways, and related software for controlling said drive (811) to have said joint (831) tilting of 90° said tilt housing (831") from said preferential vertical orientation to the horizontal orientation, and software to have said platform (26) actuating a programmed first set of forward and reverse alternate rotations of 360° about said A-axis with said tilt housing (831") along said preferentially vertical direction, and a second set of forward and reverse alternate rotations of 360° with said tilt housing (831") tilted along said preferentially horizontal direction, and further related software for controlling said arm drive (4) to have the electric center (40") of said antenna detection axis positioned over said readout positions along said programmable pathways,
a narrow-band signal processing module controlling said analyzer (18) and performing a pre-processing of said readout projection amplitudes by calculating first average and/or peak amplitudes over said first programmed set of 360° alternate rotations about said rotatory A-axis and a second average and/or peak amplitudes over said second programmed set of 360° alternate rotations, and further calculating the RMS peak and/or average readout values from said first and said second sets of rotations as the peak and/or average readout value of said vector modulus pertaining to said positions,
a module for generating said readout positions and said pathways,
a related post-processing module for correlating said readout modulus RMS value to said readout positions along said programmable pathways to produce and display said modulus spatial distribution.

5. A method according to Claim **4**, in which said antenna is an (H)E-field p-dipole (21), said detection axis is (22), said feeding conductor is (23), said detection axis (22) and said conductors (23) being mutually perpendicular, said holder is (20) and said electric center is (25).

6. A narrow-band method for automatic monitoring the spatial distribution of the modulus of the (H)E-field vector through the detection of the modulus of the field vector with the determination of three projection amplitudes of said vector over spatial readout positions along programmable pathways within extended areas and volumes, in combination with an external antenna and associated spectrum analyzer (18), said antenna being the p-dipole (21), said p- dipole having the detection axis (22) orthogonal to the direction of the feeding conductor (23), said method comprising:
- providing a robot apparatus (1) including structured arm (3) terminating with the load supporting flange (6), said flange being detachably joined to the counter-flange (7), said counter-flange being provided of shaft (8), said robot apparatus being provided of the antenna multiple configuration mechanism (5), the input of said mechanism being connected to said shaft (8), the output arm (9) of said mechanism terminating with the angled off-center p-dipole holder (24), said holder detachably mounting said p-dipole (21), said mechanism comprising turntable (26), said turntable rotating about the rotation A-axis, said holder (24) holding said feeding conductors (23) to develop a conical surface angled of 33,26° to said rotation A-axis whereby said detection axis (22) develops the related conical surface at the angle ( α) of 54° 74' to said rotation A-axis, said robot apparatus including the robot motion actuating unit (17) consisting of arm drive (4) and mechanism drive (11);
- providing a system control station (2) comprising:
said spectrum analyzer (18), said analyzer being connected to said p-dipole (12) through connector (20) and cable (19);
a programmable system processing unit (16), said processing unit controlling said robot actuating unit (17) and said analyzer (18) and is further exhibiting signal processing and post-processing features,
a system software (16') comprising:
a robot motion module comprising software for controlling said drive (11) to have said turntable (26) assuming three 120° angular readout configurations from one another about the A-axis corresponding to the p-dipole detection axis 120° angular configurations (22'), (22") and (22"'), allowing the readout of said three projection amplitudes, and related software for controlling said arm drive (4) to have the electric center (25) of said p-dipole positioned over said position (O) to be monitored along said programmable pathways,
a narrow-band signal processing module controlling said analyzer (18) and performing a pre-processing of said readout projection amplitudes by calculating the RMS value from said three projection amplitudes and recovering the readout value of said vector modulus pertaining to said position (O),
a module for generating said readout positions and said pathways,
a related post-processing module for correlating said readout modulus RMS value to said readout positions along said programmable pathways to produce and display said modulus spatial distribution.

7. A dual channel wide-band and narrow-band method for automatic monitoring the space-related spatial distributions of the (H )E-field over readout positions along programmable pathways within extended areas and volumes, in combination with the isotropic field sensor (41) and associated front-end device (18') delivering readout isotropic field intensities over said readout positions along programmable pathways within extended areas and volumes, and in combination with an external antenna and associated spectrum analyzer (18), said antenna being the p-dipole (21), said p- dipole having the detection axis (22) orthogonal to the direction of the feeding conductors (23), said analyzer delivering three projection amplitudes of said field vector for reconstructing the modulus of said vector over shifted but related readout positions along programmable pathways within said extended areas and volumes, said method comprising:
- providing a robot apparatus (101) including structured arm (3) terminating with the load supporting flange (6), said flange being detachably joined to the counter-flange (7), supporting the detachable platform (44), said platform being equipped with a first attachment member (44') and with a second attachment member (44"), said first attachment terminating with sensor holder (42) on which said sensor (41) is detachably mounted, said second member being connected to the shaft (8), said apparatus being provided of the multiple configuration mechanism (105), the input of said mechanism being connected to said shaft (8), the output arm (9) of said mechanism terminating with the angled off-center p-dipole holder (10), said holder detachably mounting said p-dipole (21), said mechanism comprising turntable (26), said turntable rotating about the rotation A-axis, said holder (24) holding said feeding conductors (23) to develop a conical surface angled of 33,26° to said rotation A-axis whereby said detection axis (14) develops the related conical surface of angle ( α) of 54° 74' to said rotation A-axis, said robot apparatus including the robot motion actuating unit (17) consisting of arm drive (4) and mechanism drive (11);
- providing a system control station (102) comprising:
said spectrum analyzer (18), said analyzer being connected to said p-dipole (21) through connector (20) and cable (19), and said front-end device (18'), said device being connected to said sensor through connector (20') and cable (19');
a programmable system processing unit (116), said processing unit controlling said robot actuating unit (17), said analyzer (18) and said front-end device (18') and is further exhibiting signal processing and post-processing features,
- a system software (116') comprising:
a robot motion module comprising arm drive (4) controller to have the electric center (43) of said sensor positioned over said readout positions along said programmable pathways, and to simultaneously have the center (25) of said detection axis (22) of said p-dipole to be positioned over said shifted but related readout positions, and a mechanism drive (11) controller to have said rotatable turntable (105') assuming three 120° angular configurations from one another about the A-axis corresponding to the p-dipole detection axis 120° angular configurations (22'), (22") and (22"'), allowing the readout of said three projection amplitudes,
a wide-band signal processing module controlling said front-end (18') and performing a pre-processing of said readout field intensities,
a narrow-band signal processing module controlling said analyzer (18) and performing a pre-processing of said readout projection amplitudes by calculating the RMS value from said three projection amplitudes and recovering the readout value of said vector modulus,
a module for generating said readout positions and said pathways,
a related post-processing module for correlating said isotropic field intensities with said readout positions of said sensor and said RMS vector modulus value with said shifted but related readout positions of said straight dipole detection axis center, along said programmable pathways, to produce and display both said space-related spatial distributions.

8. An automatic monitoring method according to Claims **6** and **7,** in which said antenna is an (H)E-field directive p-antenna (40"'), the connector (39') of said p-antenna being inclusive of said feeding conductor, said p-antenna having said detection axis (40') perpendicular to said connector (39'), said electric symmetry center is is (40").and said holder is (24).

9. A method for automatic monitoring according to Claims **6** and **7** in which said antenna is the (H)E-field b-dipole (27), said b-dipole having the detection axis (28) forming the angle of 54° 74' to the direction of the feeding conductors (29), said holder is the coaxial dipole holder (30), said holder holding coaxially said feeding conductors (29) to rotate along said rotation A-axis whereby said detection axis (28) describes a related conical surface at the angle ( α) of 54° 74' to said rotation (A), (A')and (A2) rotation axes with the center (25) of said detection axis (28) remaining over the same readout point (O) along said rotation axes.

10. An automatic monitoring method according to Claim **6** and **7,** in which said antenna is an (H)E-field directive b-antenna , said b-antenna having the detection axis (40') forming the angle of 54° 74' to the antenna holder (39'), said holder being inclusive of the b-antenna feeding conductors, said holder rotating about said (A), (A') and (A") axes whereby said detection axis (40') describes related conical surfaces at the angle ( α) of 54° 74' to said rotation axes with the center (40") of said detection axis (40') remaining over the same readout point (O) along said rotation axes.

11. An automatic method according to Claims **1 - 10** in which said arm (3) is the track guided structured arm (113) constituted by orthogonal linear movements, said arm comprising:
- including the floor standing main track (54),
- including a main base (45) guided for the movement along said main track, said base being provided of the attachment member (45'),
- including a vertically guided hoist (47), said hoist standing on the hoist stand (46), said stand (46) being detachably coupled on said attachment member (45'), said hoist terminating with said supporting flange (6),
said arm motion actuating unit (4) including a first drive to actuate said movement of said main base along said main track and a second drive to actuate said vertical movement of said hoist.

12. An automatic method according to Claims **1 - 10** in which said arm (3) is the structured arm (123) is constituted by orthogonal linear movements, said arm comprising:
including the floor standing main base (48), said main base being provided of attachment member (48'),
- including a vertically guided hoist (47), said hoist standing on the hoist stand (46), said stand being detachably coupled on said attachment member (48'),
- including a second base (49) detachably mounted on said hoist,
- including horizontal track (52) guided for the movement by said second base, said track terminating at one end with said supporting flange (6),
said arm motion actuating unit including a first drive to actuate said vertical movement of said hoist and a second drive to actuate said movement of said track (52) over said second base (49).

13. An automatic method according to Claims **1 - 10,** in which said arm (3 ) is the structured arm (133) is constituted by orthogonal linear movements, said arm comprising:
- including the floor standing main base (48), said base being provided of attachment member (48'),
- including a vertically guided hoist (47), said hoist standing on the hoist stand (46), said stand being detachably mounted on said attachment member (48'), said hoist being provided of a the attachment member (54),
- including platform (55), said platform being detachably coupled on said attachment member (54),
- including an horizontal track (56) supported by said platform (55),
- including a movable second base (57) guided for the movement along said track, said movable second base terminating with said supporting flange (6),
said arm motion actuating unit including a first drive to actuate said vertical movement of said hoist (47) and a second drive to actuate said horizontal movement of said second base (57) along said track (56).

14. An automatic method according to Claim **11**, in which said main track (54) is a multi-element track determining said movements of said main base (45), said track elements being of any shape and length and with the multi-element track assuming any pathway trajectory, said track elements being interconnected with related interconnecting means, and said first drive of said main base is actuating said movements of said base (45) all along said interconnected track.

15. An automatic method according to Claims **12** and **13**, in which said floor standing base (48) is supporting a rotatable platform preferentially swinging horizontally about a vertical axis with respect to said main base, said platform being provided of an attachment member to which said pedestal (46) of said hoist (47) is detachably coupled, said arm actuating unit (4) further including a related rotational drive to actuate said swinging movement of said rotatable platform whereby said programmable pathways occur within extended volumes.

16. An automatic method according to Claims **11**, **12** and **13,** in which said hoist is a cylinder actuator or a belt-pulley or else a geared lift device.

17. An automatic method according to Claims **1 - 10,** in which said structured arm (3) is a {x,y,z} full Cartesian arm constituted by related orthogonal linear movements.

18. An automatic method according to Claims **1 - 10**, in which said structured arm of said robot apparatus is a cylindrical arm which has three degrees of freedom constituted by one rotary, the other two being related orthogonal linear movements.

19. An automatic method according to Claims **1 - 10,** in which said structured arm of said robot apparatus is a spherical arm which has three degrees of freedom constituted by two orthogonal rotary movements and one related orthogonal linear movement.

20. An automatic monitoring method according to Claims **1 - 19**, in which said robot apparatus is constructed with parts and components made of non-metallic and/or non-conductive materials.

21. An automatic monitoring method according to Claims **1 - 19** in which said robot apparatus is constructed with said holders of said sensor and/or antennae, and/or dipoles sized and shaped whereby said sensor and/or antennae, and/or dipoles result separated from each other and from parts of said robot apparatus by a substantial separation preferably of a non integer numbers of half wavelengths until any significant EM interference is minimized.
